# EUROPEAN PATENT SPECIFICATION

(11) **EP 0 816 457 B1**
(45) Date of publication and mention of the grant of the patent: **16.08.2006**
(21) Application number: 97304592.5
(22) Date of filing: 26.06.1997
(51) Int. Cl.: C09K 3/14, C09G 1/02, C01G 45/02, H01L 21/3105, H01L 21/302, B24B 1/00, C09G 1/00

(54) **Slurry using Mn oxide abrasives and fabrication process of a semiconductor device using such a polishing slurry**
Polieraufschlämmung mit Manganoxid-Schleifkörpern und Verfahren zur Herstellung einer Halbleiteranordnung mittels einer solchen Polieraufschlämmung
Suspension de polissage utilisant des abrasifs à base d'oxyde de manganèse et procédé de fabrication d'un dispositif semiconducteur utilisant une telle suspension de polissage

(30) Priority: 27.12.1996 JP 35134296; 27.06.1996 JP 16762196
(43) Date of publication of application: 07.01.1998
(73) Proprietor: FUJITSU LIMITED, Kawasaki-shi, Kanagawa 211-8588 (JP); MITSUI MINING & SMELTING CO., LTD., Chuo-ku Tokyo 103 (JP)
(72) Inventor: Kishii, Sadahiro, Nakahara-ku, Kawasaki-shi, Kanagawa 211 (JP); Nakamura, Ko, Nakahara-ku, Kawasaki-shi, Kanagawa 211 (JP); Arimoto, Yoshihiro, Nakahara-ku, Kawasaki-shi, Kanagawa 211 (JP); Hatada, Akiyoshi, Nakahara-ku, Kawasaki-shi, Kanagawa 211 (JP); Suzuki, Rintaro, Nakahara-ku, Kawasaki-shi, Kanagawa 211 (JP); Ueda, Naruo, Mitsui Mining & Smelting Co., Ltd., Tokyo, 103 (JP); Hanawa, Kenzo, Mitsui Mining & Smelting Co., Ltd., Tokyo, 103 (JP)
(74) Representative: Lee, Nicholas John

(56) References cited:
- EP-A- 0 552 055
- JP-A- 8 115 892
- US-A- 4 405 419
- US-A- 4 585 718
- US-A- 5 453 639
- US-A- 5 468 682
- PATENT ABSTRACTS OF JAPAN vol. 015, no. 450 (C-0885), 15 November 1991 -& JP 03 193627 A (TOSOH CORP), 23 August 1991
- S. KISHII ET AL.: "Dielectric planarization using Mn2O3 slurry." PROCEEDINGS OF THE 1997 SYMPOSIUM ON VLSI TECHNOLOGY, 10 - 12 June 1997, pages 27-28, XP002101728 KYOTO, JP
- KISHII S ET AL: "WIDE FEATURE DIELECTRIC PLANARIZATION USING MNO2 SLURRY" 1996 SYMPOSIUM ON VLSI TECHNOLOGY. DIGEST OF TECHNICAL PAPERS, HONOLULU, JUNE 11 - 13, 1996,11 June 1996, page 74/75 XP000639292 INSTITUTE OF ELECTRICAL AND ELECTRONICS ENGINEERS
- CHEMICAL ABSTRACTS, vol. 107, no. 22, 16 November 1987 Columbus, Ohio, US; abstract no. 201438a, KAJYIAMA, HIROHISA: "Manufacture of metal oxide fine particles" page 181; column l; XP002101729 -& PATENT ABSTRACTS OF JAPAN vol. 11, no. 246 (C-439), 11 August 1987 & JP 62 052129 A (TOKUYAMA SODA CO., LTD.,), 6 March 1987
- KISHII S ET AL: "COMPLETELY PLANARIZED W PLUGS USING MNO2 C M P" TECHNICAL DIGEST OF THE INTERNATIONAL ELECTRON DEVICES MEETING (IEDM), WASHINGTON, DEC. 10 - 13, 1995, 10 December 1995, pages 465-468, XP000624756 INSTITUTE OF ELECTRICAL AND ELECTRONIC ENGINEERS

## Description

### BACKGROUND OF THE INVENTION

The present invention generally relates to fabrication of semiconductor devices and more particularly to a slurry for use in a CMP (chemical mechanical polishing) process used in a fabrication process of a semiconductor device as well as to a fabrication process of a semiconductor device using such a CMP process.

Semiconductor integrated circuits generally include a device isolation structure for electrically isolating adjacent semiconductor devices on a semiconductor substrate.

Conventionally, such device isolation structures have been formed by a LOCOS process, in which a thick field oxide film is formed so as to surround a device region of the semiconductor devices.

However, such a LOCOS process raises a problem in that the surface of the device region may be covered by a thin oxide film extending from the field oxide film when the size of the device regions is reduced below about 0.2 µm. This problem is known as "bird's beak." Further, such a conventional device isolation structure raises a problem in that the efficiency of device isolation is inevitably deteriorated when the distance between the semiconductor devices is reduced as a result of the device miniaturization. In such extremely miniaturized devices, the thickness of the field oxide film is inevitably reduced and hence the efficiency of the device isolation.

In order to overcome the problem of the LOCOS process in such extremely miniaturized semiconductor devices, there is a proposal to use a so-called shallow-trench isolation structure, in which a trench is formed on a semiconductor substrate between adjacent devices. The trench thus formed is filled by an insulation film.

In such conventional shallow trench isolation structures, however, there arises a problem in that the substrate formed with a trench inevitably has depressions and associated projections on a top surface thereof. Thus, there is a need for a planarization when a semiconductor device or a multilayer interconnection structure is to be formed on the substrate.

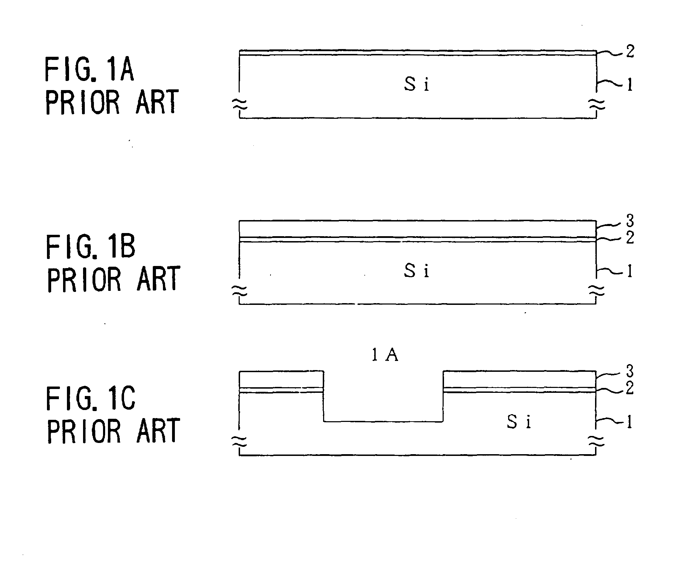

FIGS.1A - 1F show a conventional process of forming a shallow-trench isolation structure of a Si substrate.

Referring to FIG.1A, a Si substrate 1 is subjected to a thermal oxidation process at about 800°C, to form a thermal oxide film 2 with a thickness of about 5 nm.

Next, In the step of FIG.1B, a SiN film 3 is deposited on the thermal oxide film 2 typically by a CVD process with a thickness of about 200 nm, and the SiN film 3 thus deposited is subjected to an anisotropic etching process in the step of FIG.1C by using a resist mask (not shown), such that the resist mask exposes a part of the SiN film 3 corresponding to the device isolation region to be formed. As a result of the anisotropic etching process, a groove 1A reaching the substrate 1 is formed as the desired shallow-trench, with a thickness of typically 400 nm in the Si substrate 1.

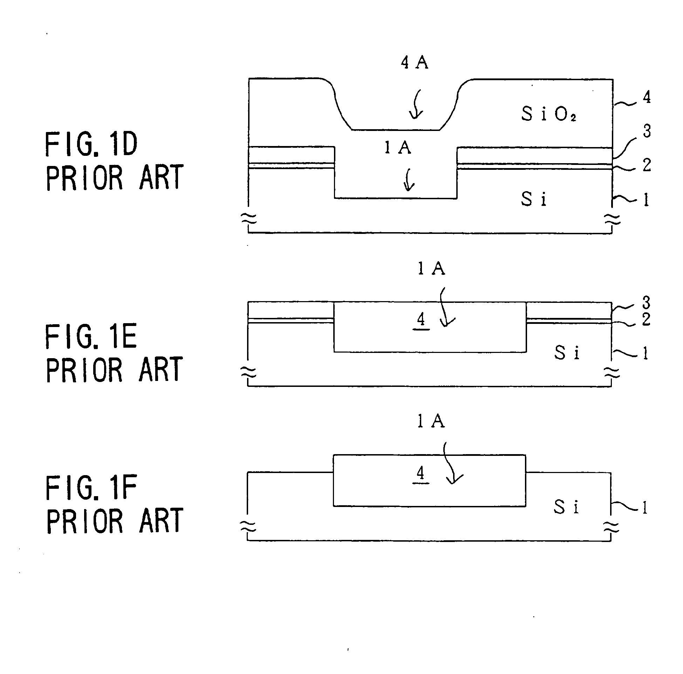

After removing the resist mask, a SiO₂ film 4 is deposited on the structure of FIG.1C in the step of FIG.1D by a CVD process with a thickness of about 700 nm. As the Si substrate 1 is formed with the foregoing groove 1A, the SiO₂ film 4 has a depression 4A corresponding to the groove 1A.

Next, in the step of FIG.1E, the SiO₂ film 4 is subjected to a planarization by a polishing process. In a typical example, the polishing of the SiO₂ film 4 is achieved by a CMP process of a slurry that uses colloidal silica (SiO₂) as abrasives. As the polishing rate achieved for an SiN film by a colloidal silica slurry is smaller than the polishing rate for an SiO₂ film (the ratio is about 5), the polishing stops spontaneously upon the exposure of the SiN film 3. In other words, the SiN film 3 acts as a polishing stopper. As a result of the polishing, a structure shown in FIG.1E is obtained, in which the groove 1A is filled with the SiO₂ film 4.

Finally, the SiN film 3 is removed and a shallow-trench isolation structure as shown in FIG.1F is obtained.

Meanwhile, recent advanced semiconductor integrated circuits generally use a so-called multilayer interconnection structure for device interconnection, in which semiconductor devices on a substrate is covered by a first interlayer insulation film, on which a first interconnection pattern is formed. The first interconnection pattern on the first interlayer insulation film is further covered by a second interlayer insulation film, and a second interconnection pattern is formed further on the second interlayer insulation film.

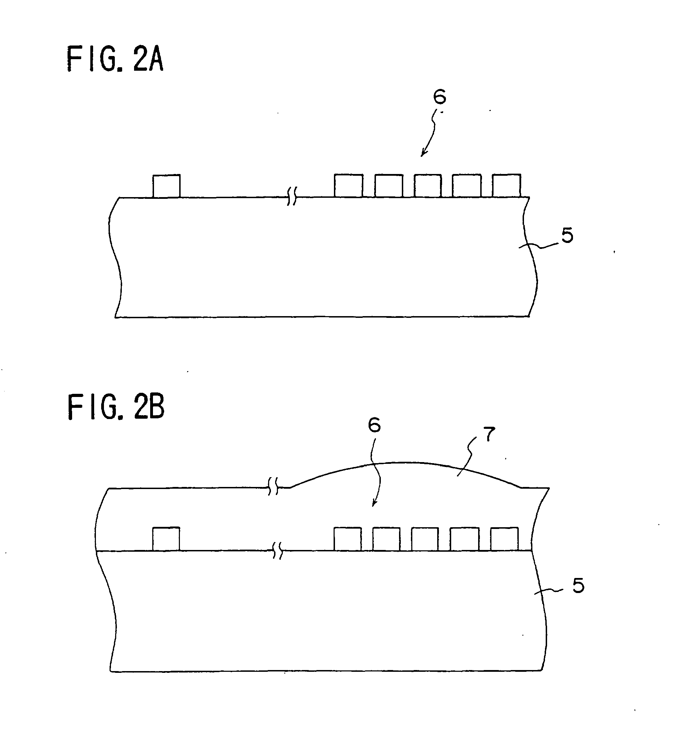

FIG.2A shows a part of the interlayer interconnection structure.

Referring to FIG.2A showing a substrate 5, the substrate 5 carries thereon an interconnection pattern 6. As the interconnection pattern 6 is formed with a density that changes location to location on the substrate 5, there generally appear projections and depressions when the interconnection pattern 6 is covered by an interlayer insulation film 7 as indicated in FIG.2B. The interlayer insulation film 7 shows a projection on the part where the interconnection pattern 6 is formed densely. When a further interconnection pattern is to be formed on the interlayer insulation film 7, therefore, it is necessary to planarize the interlayer insulation film 7.

Conventionally, the planarization of an interlayer insulation film has been made by using a low viscous material such as PSG (phosphosilicate glass), BPSG (borophosphosilicate glass), or SOG (spin-on-glass) for the interlayer insulation film. However, the use of a CMP process is becoming indispensable for planarization in recent extremely minute semiconductor devices, called sometimes submicron or sub-half-micron devices.

In the foregoing conventional process of forming a device isolation structure explained with reference to FIGS.1A - 1F, it should be noted that the SiO₂ film 4 filling the groove 1A inevitably projects from the top surface of the Si substrate 1 after the removal of the SiN film 3 that has been used as a polishing stopper. In other words, the structure thus obtained is not completely planarized but includes a projection caused by the SiO₂ film 4. Of course, such a projection causes a problem when forming a multilayer interconnection structure on the substrate 1.

Further, the foregoing conventional process may lead to the problem in which the SiN film 3 may be partially removed in the polishing step of FIG.1E due to the insufficient selectivity in the polishing rate between the SiO₂ film 4 and the SiN film 3. When this occurs, the thin thermal oxide film 2 underneath the SiN film 3 is easily removed as a result of the polishing, and the Si substrate 1 may be exposed. Once exposed, the Si substrate 1 experiences an extensive grooving in the part thus exposed. It should be noted that the polishing rate increases in the order of SiN, SiO₂ and Si when a CMP process is applied with a colloidal silica slurry.

Further, it is preferable to eliminate the step of FIG.1F for removing the SiN film 3, as such an extra step increases the number of the fabrication steps of a semiconductor device.

In relation to the formation of the shallow-trench isolation structure, the inventors of the present invention previously discovered that a slurry that uses MnO₂ as abrasives is effective for polishing an insulation film such as an SiO₂ film and made a proposal of such a slurry as well as of a fabrication process of a semiconductor device by using the slurry. The slurry that uses MnO₂ abrasives itself is also proposed previously (Japanese Laid-open Patent Publication 9-22888). The slurry that uses MnO₂ abrasives is particularly useful for polishing a conductor layer such as W. Thus, the slurry is applicable for polishing both a conductor layer and an insulation film. This means that the same slurry can be used for polishing a conductor layer and an insulation layer, without changing the slurry. Thereby, the fabrication process of the semiconductor device is substantially simplified.

As noted above, the slurry that uses MnO₂ abrasives is effective not only for polishing an insulation film but also for polishing a conductor layer. This means that the polishing does not stop spontaneously upon the exposure of the Si substrate 1 and that the use of a polishing stopper, such as TiN or similar nitride, is necessary or inevitable in the formation of the shallow-trench isolation structure, similarly to the SiN film 3. Thereby, the foregoing problem of projection of the SiO₂ layer 4 remains unsolved.

In the formation of the multilayer interconnection structure of FIGS.2A and 2B, on the other hand, it has been practiced to carry out the planarization of the interlayer insulation film 7 by a CMP process that uses a colloidal silica slurry, in which colloidal silica (SiO₂) abrasives are used. However, the polishing rate that can be achieved by a such colloidal silica slurry is at best 65 nm/min, and it has been difficult to control the thickness of the interlayer insulation film exactly by using a polishing stopper pattern underneath the interlayer insulation film. In order to use the polishing stopper effectively, it is necessary to polish the interlayer insulation film all the way until the polishing stopper is exposed.

Because of the difficulty of controlling the thickness of the interlayer insulation film exactly as such, it has been practiced to estimate the degree of planarization achieved by a CMP process merely based upon the duration of polishing in the conventional planarization process that uses a colloidal silica slurry. However, such an estimation never guarantees the actual planarization of the interlayer insulation film.

### SUMMARY OF THE INVENTION

Accordingly, it is a general object of the present invention to provide a novel and useful slurry for a CMP process as well as a fabrication process of a semiconductor device that uses such a CMP process, wherein the foregoing problems are eliminated.

Another and more specific object of the present invention is to provide a slurry that acts selectively upon an insulation film such as an SiO₂ film while not acting effectively upon a conductor layer or a semiconductor layer including a Si substrate.

Another object of the present invention is to provide a method of fabricating a semiconductor device including a polishing step of an insulation film by a chemical mechanical polishing process that acts selectively upon said insulation film while not acting effectively upon a conductor layer or a semiconductor layer including a Si substrate.

According to a first aspect of the present invention, there is provided a use of a slurry for polishing an insulation film, the said slurry comprising: abrasive particles causing polishing of said insulation film; and a solvent in which said abrasive particles are dispersed, said abrasive particles being selected from a group consisting of Mn₂O₃, Mn₃O₄ and a mixture thereof. According to the present invention, the slurry acts selectively upon an insulation layer as compared to a conductor or semiconductor layer and is effective for polishing an insulation layer in the fabrication process of a semiconductor device.

According to a second aspect of the present invention, there is provided a method of polishing an insulation film, comprising the step of: polishing said insulation film by a slurry comprising abrasive particles and a solvent, said abrasive particles being selected from a group consisting of Mn₂O₃, Mn₃O₄ and a mixture thereof. By using Mn₂O₃ or Mn₃O₄ abrasives in the polishing process, it is possible to polish the insulation film with a rate at least three times as large as a polishing rate achieved by a colloidal silica slurry for the same insulation film while simultaneously suppressing the polishing rate for a metal or a semiconductor. Thereby, the polishing of the insulation film stops spontaneously in a structure in which an underlying layer of a metal or a semiconductor is provided underneath the insulation film, upon the exposure of the underlying layer. The Mn₂O₃or Mn₃O₄abrasive particles can be formed in-situ in the solvent, by using abrasive particles of MnO₂ in combination with a solvent of which oxidation-reduction potential and pH are suitably adjusted.

Other objects and further features of the present invention will become apparent from the following detailed description when read in conjunction with the attached drawings.

### BRIEF DESCRIPTION OF THE DRAWINGS

FIGS.1A - 1F are diagrams showing a conventional process of forming a device isolation film, upon the exposure of the underlying layer. The Mn₂O₃ or Mn₃O₄ abrasive particles can be formed in-situ in the solvent, by using abrasive particles of MnO₂ in combination with a solvent of which oxidation-reduction potential and pH are suitably adjusted.

According to a fifth aspect of the present invention, there is provided a fabrication process of a semiconductor device including a polishing step, comprising the step of:
polishing an insulation layer provided on an underlying layer selectively by a slurry, said underlying layer being one of a conductor layer and a semiconductor layer;
said slurry comprising: abrasive particles of manganese oxide, selected from a group consisting of Mn₂O₃, Mn₃O₄ and a mixture thereof; and a solvent in which said abrasive particles are dispersed.

According to the present invention, the polishing step of the insulation layer stops spontaneously upon the exposure of the underlying conductor or semiconductor layer, without using an additional polishing stopper layer, particularly when the abrasive particles are selected from a group consisting of Mn₂O₃, Mn₃O₄ and a mixture thereof. The underlying conductor or semiconductor layer itself acts as a polishing stopper. Thereby, the fabrication process such as the fabrication process of shallow trench structure or a planarization of an interlayer insulation film is substantially facilitated.

Other objects and further features of the present invention will become apparent from the following detailed description when read in conjunction with the attached drawings.

### BRIEF DESCRIPTION OF THE DRAWINGS

FIGS.1A - 1F are diagrams showing a conventional process of forming a device isolation structure;
FIGS.2A and 2B are diagrams showing a conventional process of forming a multilayer interconnection structure;
FIG.3 is a phase diagram showing an oxidation-reduction reaction of Mn;
FIGS.4A - 4C are diagrams showing a process of formation of a device isolation structure according to a first embodiment of the present invention;
FIG.5 is a diagram showing the result of the fabrication process of the first embodiment in comparison with a conventional process;
FIGS.6A - 6L are diagrams showing a fabrication process of a semiconductor device according to a second embodiment of the present invention;
FIGS.7A - 7M are diagrams showing a fabrication process of a semiconductor device according to a third embodiment of the present invention;
FIG.8 is a flowchart showing a production process of a manganese oxide slurry according to a fourth embodiment of the present invention;
FIGS.9A - 9C are X-ray diffraction diagrams showing the change of composition of the produced manganese oxide during the production process of the third embodiment;
FIG.10 is a flowchart showing a recovery and reproduction process of abrasives according to a fifth embodiment of the present invention;
FIG.11 is a diagram showing the construction of an apparatus used for the recovery and reproduction process of abrasives according to the fifth embodiment; and
FIG.12 is a diagram showing the construction of a recovery tank used in the fifth embodiment of the present invention.

### DETAILED DESCRIPTION OF THE PREFERRED EMBODIMENT [PRINCIPLE]

The inventors of the present invention conducted a series of experiments on CMP process, in which various materials were polished by using abrasives of Mn₂O₃ as well as other abrasives of various compositions. The inventors thereby discovered that an SiO₂ film can be polished by a slurry using Mn₂O₃ abrasives, with a rate of at least three or four times as large as the polishing rate achieved when a conventional colloidal silica slurry is applied to the same SiO₂ film. Further, it was discovered that the slurry that uses the Mn₂O₃ abrasives is substantially ineffective for polishing a metal such as W or a semiconductor material such as Si. A similar effect was confirmed also for the slurry that uses MnO₂ abrasives in which the surface of the abrasives is treated in a condition that forms Mn₂O₃ thereon.

**TABLE I**

| | SiO₂ | Si | W |
|---|---|---|---|
| Mn₂O₃ | 0.2-0.25µm/min | 0.045-0.050µm/min | 0.048µm/min |
| colloidal silica | 0.065 µm/min | 0.13 µm/min | |

**TABLE II**

| | | |
|---|---|---|
| manganese oxide | grain size concentration | 0.2 µm in slurry10 wt% |
| abrasive cloth | IC1000/SUBA400 | |
| flow rate | 150 cc/min | |
| urging pressure | 0.21 kg/cm² | |
| platen diameter | 12 inches | |
| rotational speed | head 60 rpm, | platen 60 rpm |

TABLE I shows the summary of the foregoing experiment, wherein it should be noted that the experiment was conducted under the condition summarized in TABLE II.

More specifically, the polishing was made by using abrasives of Mn₂O₃ having an average grain size of about 0.2 µm under a condition in which the Mn₂O₃ abrasives are dispersed in a solvent of H₂O with a concentration of about 10 wt%. As indicated in TABLE II, the polishing was conducted on a platen of 12 inches diameter rotating at a speed of 60 rpm, while urging a polishing head, on which a work to be polished is held, with an urging pressure of 210g/cm². The polishing head was rotated with a speed of 60 rpm. Further, the slurry was supplied with a rate of 100 cc/min.

As can be seen clearly from TABLE I, a polishing rate of 200 - 250 nm/min is obtained for an SiO₂ film when a slurry that uses the Mn₂O₃ abrasives is employed, while this polishing rate is about three or four times as large as the polishing rate of 65 nm/min, which is obtained by a conventional colloidal silica slurry for the same SiO₂ film.

TABLE I further indicates that the polishing rate achieved for Si or W by the slurry that uses the Mn₂O₃ abrasives is very small, about 45 nm/min and 48 nm/min respectively. In other words, a metal layer or a Si layer can be used in combination with an SiO₂ film as an efficient polishing stopper when the slurry that uses the Mn₂O₃ abrasives is used for polishing the SiO₂ film. A similar effect is obtained also for a slurry that uses Mn₃O₄ abrasives.

In contrast, it should be noted that the polishing rate achieved for a Si layer or substrate by a conventional colloidal silica slurry is very large, in the order of as much as 120 nm/min. This indicates that a Si layer cannot be used as an effective polishing stopper as long as the colloidal silica slurry is used for polishing a SiO₂ or silicate glass film.

Further, the inventors of the present invention discovered that an excellent selectivity of polishing similar to that obtained by the Mn₂O₃ abrasives, can be achieved also when abrasives of MnO₂ are used under a condition that induces a formation of Mn₂O₃ or Mn₃O₄ on the surface of the MnO₂ abrasives.

It should be noted that a metal element such as Mn that takes different valence states can form various different oxides as a result of oxidation-reduction reaction, which changes the valence state.

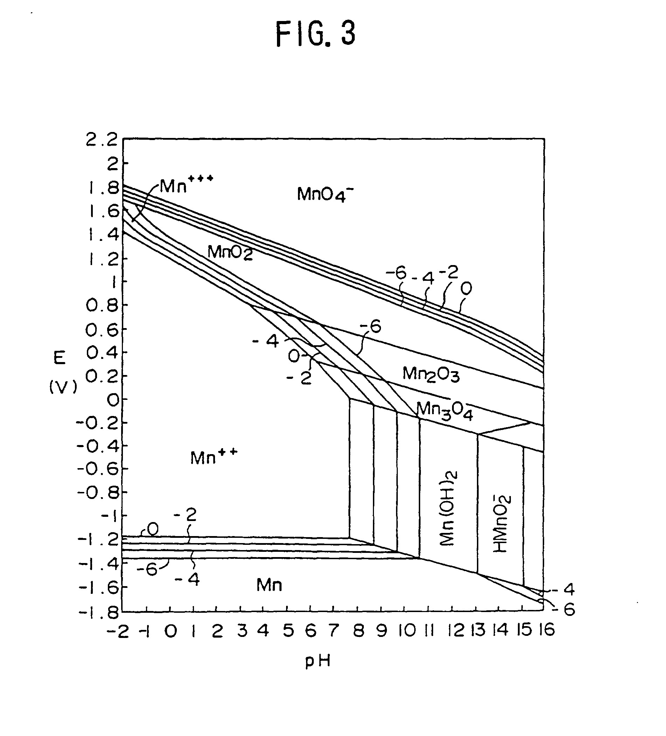

FIG.3 is a phase diagram showing an oxidation-reduction reaction of Mn in an aqueous solution. In FIG.3, it should be noted that the horizontal axis represents pH (hydrogen ion exponent) while the vertical axis represents oxidation-reduction potential E.

Referring to FIG.3, it should be noted that the E-pH field of FIG.3 is divided into a plurality of regions by phase boundaries each corresponding to an oxidation-reduction reaction of Mn. For example, it will be noted that MnO₂ is obtained as the Mn oxide in the region in which E is 0.8 - 1 V and pH is 6 - 7, while one obtains Mn₂O₃ or Mn₃O₄ as a Mn oxide in the region in which pH is larger and E is smaller. In FIG.3, it should be noted that the phase boundaries designated by "0," "-2," "-4," and "-6" indicate Mn⁺⁺ concentrations of 1M/l, 0.01 M/l, 0.0001 M/l, and 0.000001 M/l, respectively.

Thus, the inventors of the present invention prepared a slurry based upon a previously proposed slurry that uses MnO₂ abrasives (Japanese Laid-Open Patent Publication 9-22888) by adjusting the values of pH and E of the solvent, which constitutes the slurry together with the abrasives, such that Mn₂O₃ or Mn₃O₄ is formed on the surface of the abrasive particles. The polishing rate achieved for an SiO₂ film by using the MnO₂ abrasives thus covered by Mn₂O₃ or Mn₃O₄, also exceeds the polishing rate achieved by the conventional colloidal silica slurry. Further, a remarkable reduction of the etching rate is observed also when polishing a metal such as W or a semiconductor such as Si. In other words, the slurry shows a selectivity of polishing similar to the slurry that uses Mn₂O₃ or Mn₃O₄ abrasives.

It should be noted that the value of pH can be adjusted easily by adding an acid such as HCl or alkali such as KOH. Further, the oxidation-reduction potential can be adjusted easily by adding an ozone water or a bubbling of H₂. The oxidation-reduction potential increases with the addition of ozone water and decreases with the bubbling of H₂.

### [FIRST EMBODIMENT]

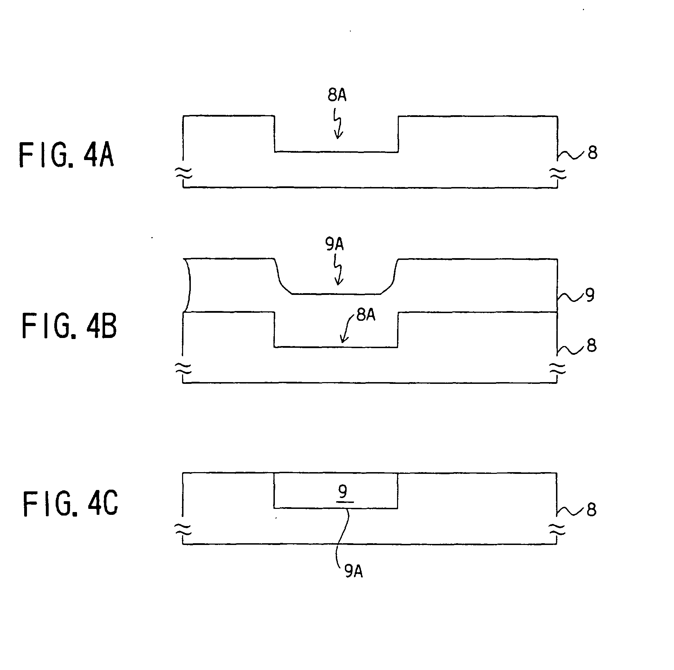

FIGS.4A - 4C show a fabrication process of a semiconductor device according to a first embodiment of the present invention, particularly with regard to the formation of a shallow-trench device isolation structure.

Referring to FIG.4A, a Si substrate 8 corresponding to the Si substrate 1 of FIG.1A is formed with a device isolation groove 8A with a depth of about 400 nm, followed by a deposition of a SiO₂ film 9 by a CVD process such that the SiO₂ film 9 fills the groove 9A as indicated in FIG.4B.

Next, in the step of FIG.4C, the SiO₂ film 9 is subjected to a CMP process by using a slurry shown in TABLE I in which Mn₂O₃ particles are dispersed as abrasives in a solvent of H₂O. The polishing is conducted under the condition represented in TABLE II, wherein the polishing stops spontaneously upon the exposure of the Si substrate 8 due to the selectivity of polishing with respect to SiO₂. As represented in TABLE I, a selectivity ratio of at least four is secured in terms of the polishing rate between SiO₂ and Si by using such a slurry that contains Mn₂O₃ as the abrasives.

In the process of FIGS.4A - 4C, it should be noted that the surface of the Si substrate 8 itself acts as a polishing stopper, and the steps of providing an additional polishing stopper before the CMP process or removing the same thereafter as in the case of FIGS.1A - 1F can be successfully eliminated.

In the polishing step of FIG.4C, it is also possible to use MnO₂ in the slurry as the abrasives by adjusting the oxidation-reduction potential and pH of the solvent such that Mn₂O₃ or Mn₃O₄ are formed on the surface of the abrasive particles. By doing so, it is possible to achieve an efficient polishing of the SiO₂ film 9 similarly to the case of using the Mn₂O₃ abrasives in the slurry, as well as an efficient selectivity of polishing. Further, a similar spontaneous stopping of the polishing is achieved upon the exposure of the Si substrate 8.

According to this process that uses MnO₂ abrasive particles in the slurry, it is possible to use the same slurry used for polishing a conductor layer such as a W layer, also for the polishing an SiO₂ film, by merely adjusting the composition of the solvent. Thereby, the step of exchanging the slurry when polishing a conductor layer or when polishing an insulation, can be eliminated. By setting the oxidation-reduction potential E to 0 V and pH to 12 or more, for example, the surface of the MnO₂ abrasive particles is covered by Mn₂O₃.

After the polishing step of FIG.4C, the structure of FIG.4C is immersed in a cleaning solution that contains HCl, H₂O₂ and H₂O with a volumetric ratio of 1 : 1 : 48 for 1 minute, followed by an immersion into an HF aqueous solution of 0.5% concentration for removal of impurities. A chemical analysis conducted after such a cleaning process for various impurity elements (Na, K, Fe, Mn) indicated that a cleanness of 5 x 10¹⁰atoms/cm² is realized for the substrate surface. Further, no defects such as scars were observed on the surface of the Si substrate 8 or the SiO₂ film 9 after the polishing process.

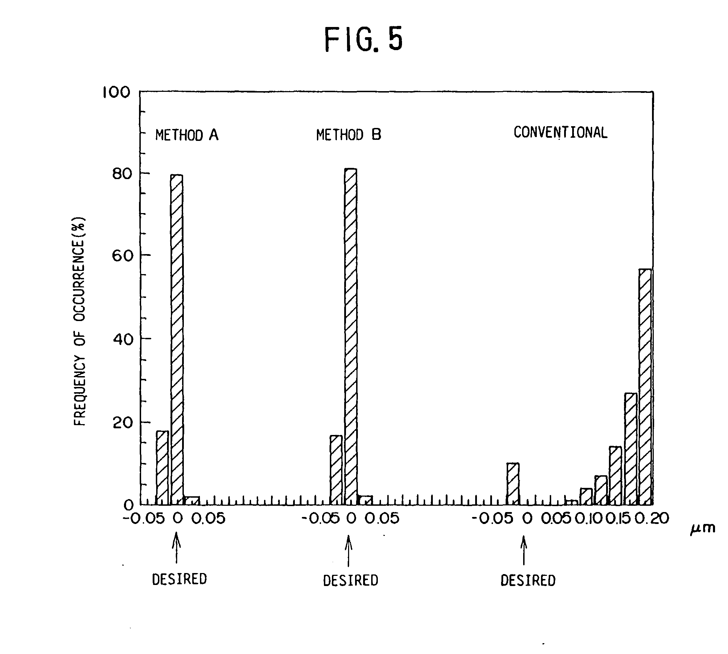

FIG.5 shows the step height formed by the SiO₂ film 9 on the Si substrate 8 in the structure of FIG.4C in comparison with the result for the conventional structure of FIG.1F, wherein the horizontal axis of FIG.5 represents the step height while the vertical axis represents the frequency of occurrence. In FIG.5, the method designated "A" represents the case in which the Mn₂O₃ abrasives are used in the slurry while the method designated "B" indicates the case in which Mn₂O₃ is formed on the surface of the MnO₂ abrasives.

Referring to FIG.5, any of the methods "A" and "B" provides a step height of less than 0.05 *µ*m, as compared with the conventional process in which the step height can reach as much as 2 µm.

The result of FIG.5 clearly indicates that the CMP process of the present invention is extremely effective for planarizing the surface of the substrate 8 on which a shallow-trench isolation structure is formed.

In the present embodiment, it is also possible to use Mn₃O₄ abrasives or a mixture of Mn₂O₃ and Mn₃O₄ abrasives for the slurry in place of the Mn₂O₃ abrasives.

### [SECOND EMBODIMENT]

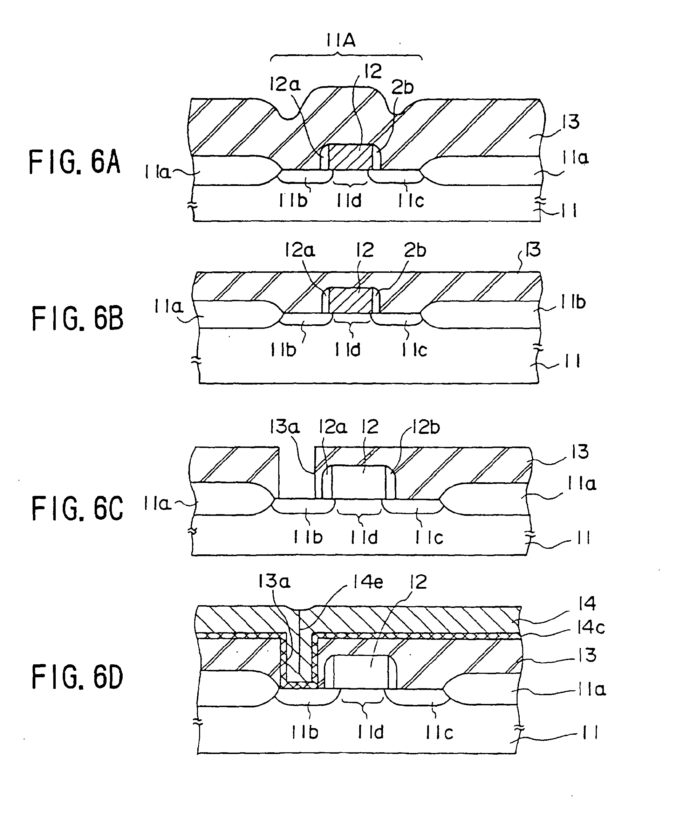

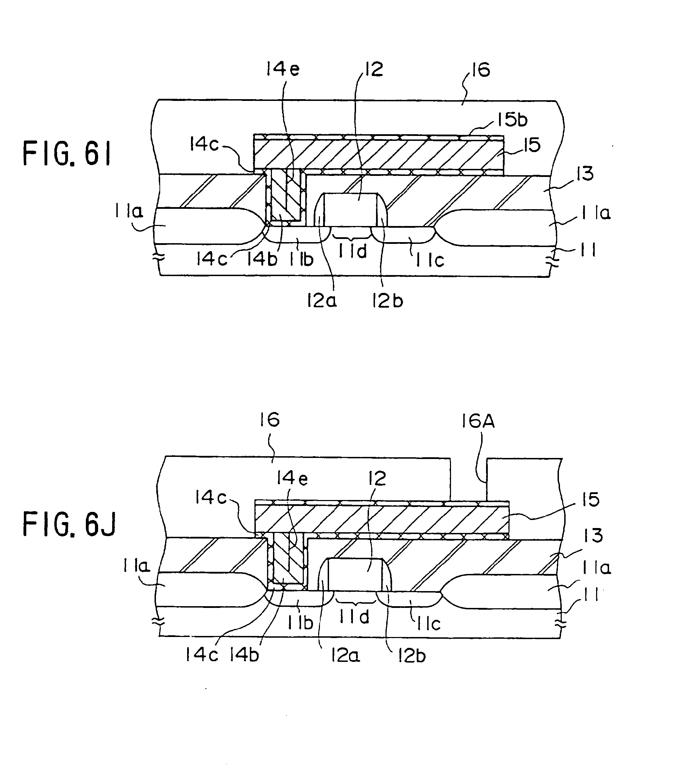

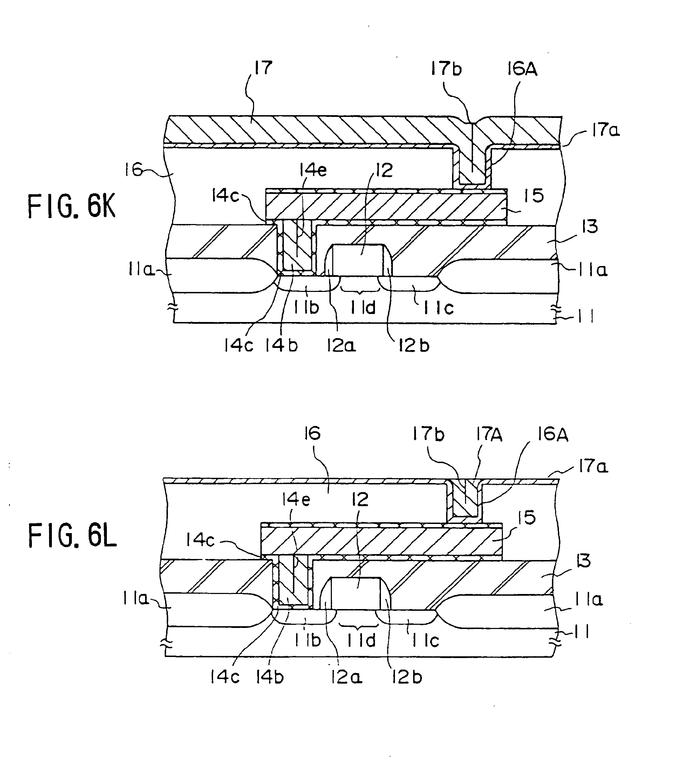

FIGS.6A - 6L are diagrams showing the fabrication process of a semiconductor device including a multilayer interconnection structure according to a second embodiment of the present invention.

Referring to FIG.6A, a Si substrate 11 is defined with an active region 11A by a field oxide film 11a, and a gate electrode 12 is provided on the substrate 11 in the active region 11A, with a gate insulation film (not shown) intervening between the substrate 11 and the gate electrode 12. Further, the substrate 11 is formed with diffusion regions 11a and 11b at both sides of the gate electrode 12 and a channel region 11d is defined in the substrate 11 immediately below the gate electrode 12. The gate electrode 12 carries side wall oxide films 12a and 12b at both lateral side walls thereof, and an interlayer insulation film 13 typically of SiO₂ is provided on the substrate 11 by a CVD process such that the interlayer insulation film 13 covers the gate electrode 12 including the side wall oxide films 12a and 12b.

As will be noted from FIG.6A, the interlayer insulation film 13 thus formed has a projection and depression at a top surface thereof in correspondence to the gate electrode 12, and thus, the structure of FIG.6A is planarized in the step of FIG.6B by polishing the interlayer insulation film by a CMP process that uses a slurry, in which abrasives of Mn₂O₃ or Mn₃O₄ are dispersed in a suitable solvent such as H₂O. As explained already with reference to TABLE I, a polishing rate of more than three times as large as the conventional polishing rate is achieved by using a slurry that contains Mn₂O₃ abrasives for this purpose. Further, a polishing rate of more than twice as large as the conventional polishing rate is obtained when a slurry that contains Mn₃O₄ abrasives is used for the same purpose.

Next, in the step of FIG.6C, the interlayer insulation film 13 thus planarized is formed with a contact hole 13a so as to expose the diffusion region 11b, and a TiN layer 14c and a W layer 14 are deposited on the structure of FIG.6C consecutively by a sputtering process or a CVD process.

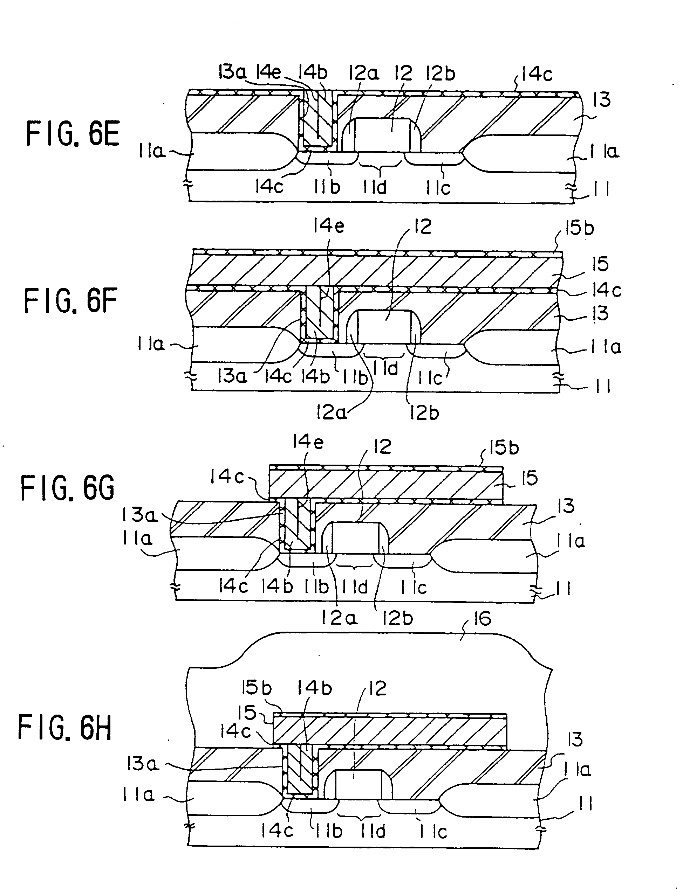

The W film 14 thus deposited is then removed in the step of FIG.6E by a CMP process that uses MnO₂ abrasives, and a structure in which a W plug 14b fills the contact hole 13a is obtained as indicated in FIG.6E. In the process of FIG.6E, it should be noted that the TiN layer 14c remains more or less intact. While the W plug 14b thus formed includes a seam 14e at a central part thereof as a result of the lateral growth of the W layer in the contact hole 13a at the time of the deposition, the problem of erosion of the seam by a liquid oxidant such as H₂O₂ is successfully avoided by using the MnO₂ abrasives. It should be noted that the MnO₂ abrasives in the slurry acts as a solid oxidant and does not penetrate into the seam 14e even during the polishing process of the W layer 14.

Next, in the step of FIG.6F, a thin Ti film (not shown) is formed on the structure of FIG.6E by a sputtering process or a CVD process, and a conductor layer 15 of Al or an Al alloy is formed on the structure of FIG.6E. Further, a thin Ti layer (not shown) is deposited on the conductor layer 15, and a TiN layer 15b is formed further thereon by a sputtering process or a CVD process.

Next, in the step of FIG.6G, the conductor layer 15 as well as the TiN layers 14c and 15b are patterned, and the structure thus obtained is covered by an interlayer insulation film 16 of typically SiO₂ in the step of FIG.6H. It should be noted that the interlayer insulation film 16 thus formed shows a projection at the top surface thereof in correspondence to the foregoing conductor pattern 15.

Next, in the step of FIG.6I, the interlayer insulation film 16 is planarized by a CMP process that uses Mn₂O₃ or Mn₃O₄ abrasives in the slurry. Further, the interlayer insulation film 16 thus planarized is patterned in the step of FIG.6J, wherein a contact hole 16A is formed so as to expose the conductor layer 15. Further, a TiN layer 17a and a W layer 17 are deposited consecutively on the interlayer insulation film 16 in the step of FIG.6K so as to fill the contact hole 16, and a step of FIG.6L is conducted in which the W layer 17 is removed by a CMP process that uses MnO₂ abrasives in the slurry. As a result of the polishing, a conductive plug 17A is formed so as to fill the contact hole 16A. Similarly as before, the conductive plug 17A may include a seam 17b at the central part thereof.

Further, another interconnection pattern or an interlayer insulation film may be provided on the structure of FIG.6L.

In the foregoing fabrication process of the semiconductor device, it should be noted that a planarization is applied to the insulation film 13 or the interlayer insulation film 16 of SiO₂ in the step of FIG.6B or FIG.6I by a CMP process that uses abrasives of Mn₂O₃, Mn₃O₄ or a mixture thereof in the slurry. It is also possible to conduct the foregoing CMP process by a slurry that uses MnO₂ abrasives in combination with a solvent of which composition is adjusted fore realizing the oxidation-reduction potential and pH represented in the phase diagram of FIG.3. Further, the removal of the conductor layer 14 or 17 of W is conducted in the step of FIG.6E or FIG.6L by a CMP process that uses MnO₂ abrasives.

As explained already, the abrasives of MnO₂, Mn₂O₃ or Mn₃O₄ are soluble to an acid, and thus, any residual abrasives remaining in the substrate (work) or in the polishing rig or apparatus can be removed easily by an acid cleaning process. For this purpose, a cleaning solution containing HCl, H₂O₂ and H₂O with a volumetric ratio of 1:1:48 may be used as described already.

### [THIRD EMBODIMENT]

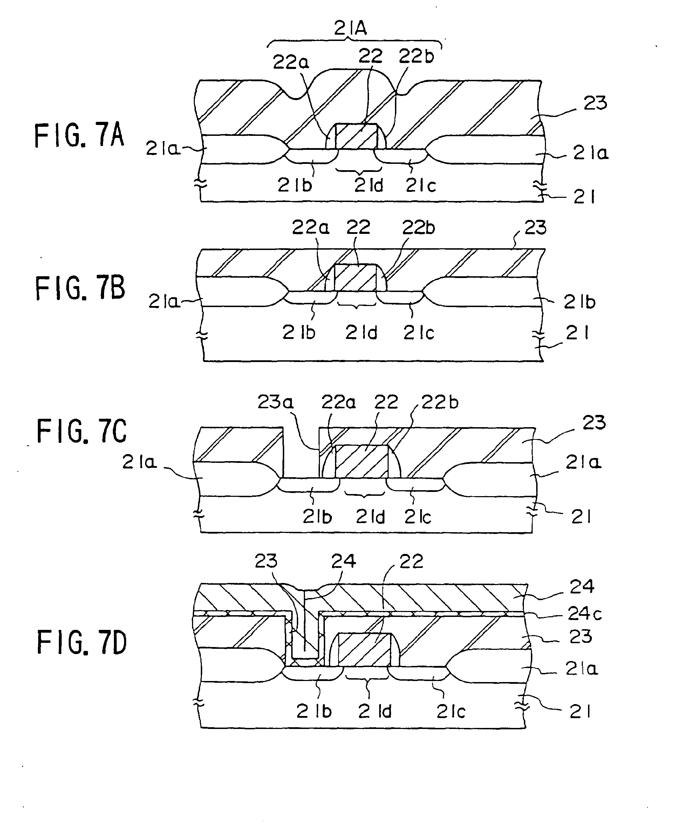

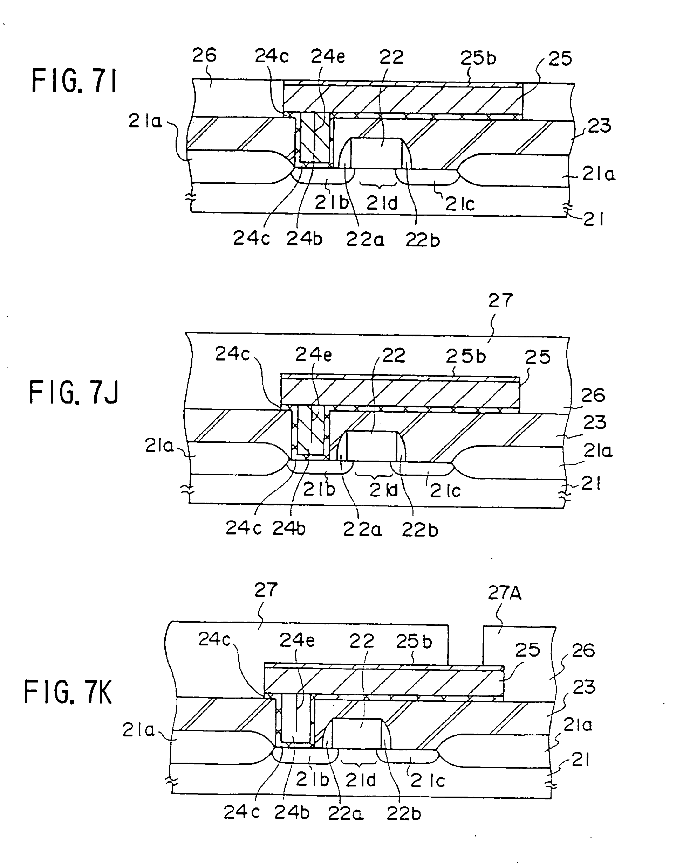

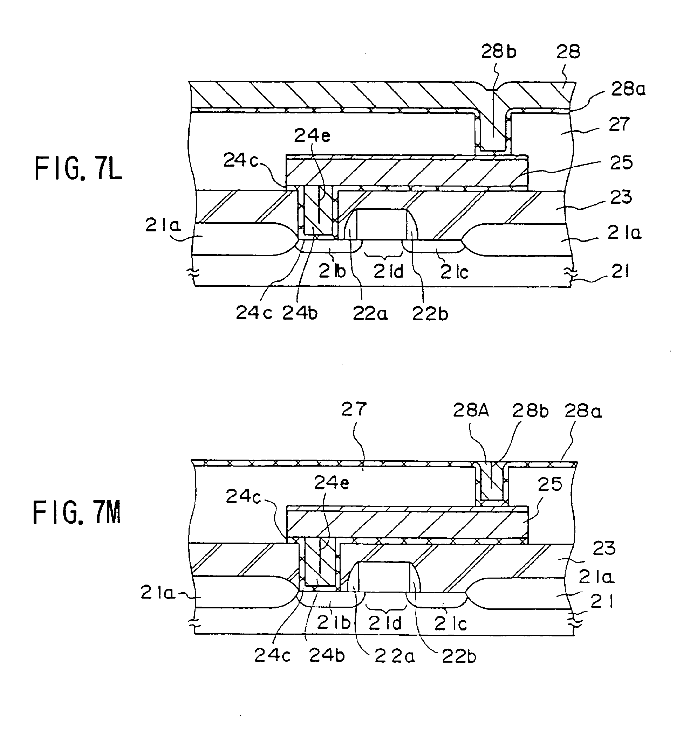

FIGS.7A - 7L are diagrams showing the fabrication process of a semiconductor device including a multilayer interconnection structure according to a third embodiment of the present invention.

Referring to FIG.7A, a Si substrate 21 corresponding to the Si substrate 11 is defined with an active region 21A by a field oxide film 21a, and a gate electrode 22 is provided on the substrate 21 in the active region 21A, with a gate insulation film (not shown) intervening between the substrate 21 and the gate electrode 22. Further, the substrate 21 is formed with diffusion regions 21a and 21b at both sides of the gate electrode 22 and a channel region 21d is defined in the substrate 21 immediately below the gate electrode 22. The gate electrode 22 carries side wall oxide films 22a and 22b at both lateral side walls thereof, and an interlayer insulation film 23 typically of SiO₂ is provided on the substrate 21 by a CVD process such that the interlayer insulation film 23 covers the gate electrode 22 including the side wall oxide films 22a and 22b.

As will be noted from FIG.7A, the interlayer insulation film 23 thus formed has a projection and depression at a top surface thereof in correspondence to the gate electrode 22, and thus, the structure of FIG.7A is planarized in the step of FIG.7B by polishing the interlayer insulation film by a CMP process that uses a slurry, in which abrasives of Mn₂O₃ or Mn₃O₄ are dispersed in a suitable solvent such as H₂O. As explained already with reference to TABLE I, a polishing rate of more than three times as large as the conventional polishing rate is achieved by using a slurry that contains Mn₂O₃ abrasives for this purpose. Further, a polishing rate of more than twice as large as the conventional polishing rate is obtained when a slurry that contains Mn₃O₄ abrasives is used for the same purpose.

Next, in the step of FIG.7C, the interlayer insulation film 33 thus planarized is formed with a contact hole 23a so as to expose the diffusion region 21b, and a TiN layer 24c and a W layer 24 are deposited on the structure of FIG.7C consecutively by a sputtering process or a CVD process.

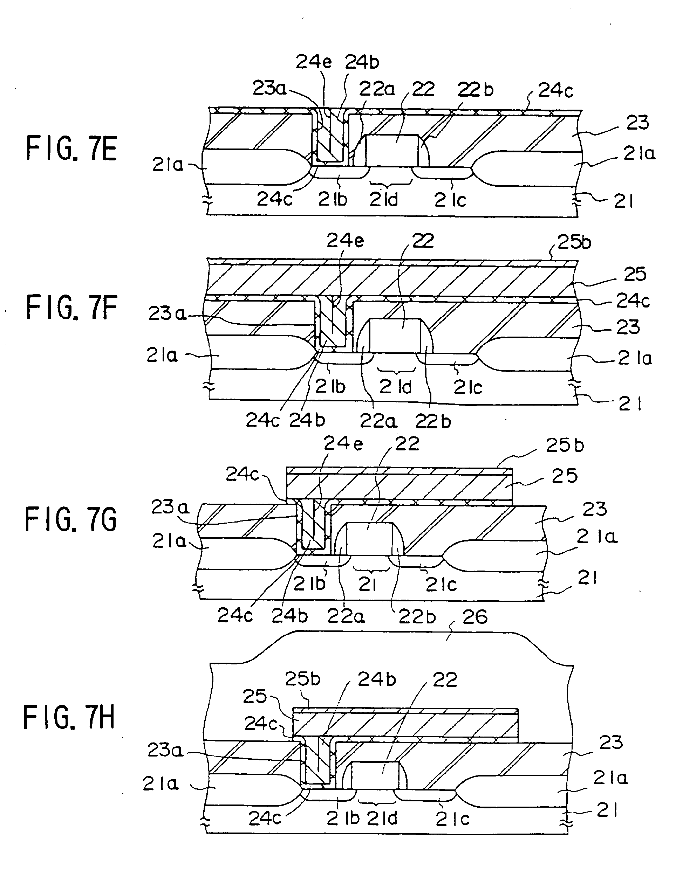

The W film 24 thus deposited is then removed in the step of FIG.7E by a CMP process that uses MnO₂ abrasives, and a structure in which a W plug 24b fills the contact hole 23a is obtained as indicated in FIG.7E. In the process of FIG.7E, it should be noted that the TiN layer 24c remains more or less intact. While the W plug 24b thus formed includes a seam 24e at a central part thereof as a result of the lateral growth of the W layer in the contact hole 23a at the time of the deposition, the problem of erosion of the seam by a liquid oxidant such as H₂O₂ is successfully avoided by using the MnO₂ abrasives. It should be noted that the MnO₂ abrasives in the slurry acts as a solid oxidant and does not penetrate into the seam 24e even during the polishing process of the W layer 24.

Next, in the step of FIG.7F, a thin Ti film (not shown) is formed on the structure of FIG.7E by a sputtering process or a CVD process, and a conductor layer 25 of Al or an Al alloy is formed on the structure of FIG.7E. Further, a thin Ti layer (not shown) is deposited on the conductor layer 25, and a TiN layer 25b is formed further thereon by a sputtering process or a CVD process.

Next, in the step of FIG.7G, the conductor layer 25 as well as the TiN layers 24c and 25b are patterned, and the structure thus obtained is covered by an interlayer insulation film 26 of typically SiO₂ in the step of FIG.7H. It should be noted that the interlayer insulation film 26 thus formed shows a projection at the top surface thereof in correspondence to the foregoing conductor pattern 25.

Thus, in the step of FIG.7I, the interlayer insulation film 26 of FIG.7H is planarized by a CMP process that uses Mn₂O₃ or Mn₃O₄ abrasives in the slurry, until the TiN layer 25b covering the conductor layer 25 is exposed.

**TABLE III**

| Mn₂O₃ | Mn₃O₄ | silica |
|---|---|---|
| 0.2-0.25 µm/min | 0.15-0.20 µm/min | 0.065 µm/min |

TABLE III represents the polishing rate of the slurry that uses Mn₂O₃ or Mn₃O₄ abrasives as applied to an SiO₂ film, wherein the polishing condition is given in TABLE II. For the sake of comparison, the polishing rate of a conventional colloidal silica slurry (SC112) for an SiO₂ film is also listed. As will be seen clearly in TABLE III, the slurry that uses Mn₂O₃ abrasives provides a polishing rate of three or four times as large as the conventional polishing rate achieved by the colloidal silica slurry. Similarly, the slurry that uses Mn₃O₄ abrasives provides a polishing rate of two or three times as large as the foregoing conventional polishing rate. In TABLE III, it should be noted that the polishing rates for the Mn₂O₃ slurry and the colloidal slurry correspond to the polishing rates in TABLE I.

As the polishing rate obtained by the slurry that uses Mn₂O₃ or Mn₃O₄ slurry is very large as compared with the polishing rate of the conventional colloidal silica slurry, the polishing of the interlayer insulation film 26 proceeds rapidly until the TiN layer 25b on the conductor layer 25 is exposed. Thereby, the thickness of the interlayer insulation film 26 remaining on the interlayer insulation film 23 is controlled exactly, in the state of FIG.7I, by the thickness of the conductor layer 25. As the thickness of the conductor layer 25 can be controlled exactly at the time of the deposition, the thickness of the interlayer insulation film 26 is also controlled exactly. Further, it should be noted that the CMP process that uses the Mn₂O₃ or Mn₃O₄ abrasives in the slurry does not act substantially upon a nitride film such as the TiN film 25b. Thus, the TiN film 25b can be used as an effective polishing stopper. Further, the polishing stops more or less spontaneously even when the TiN film 25b is formed on the conductor layer 25 due to the very small polishing rate of the slurry with respect to the conductor layer 25, which may be formed of W. See TABLE I. It should be noted that a similar very large polishing rate is achieved also for the interlayer insulation film 26 when the interlayer insulation film 26 is formed of a silicate glass such as PSG or BPSG.

After the step of FIG.7I, another interlayer insulation film 27 is formed on the interlayer insulation film 26 thus planarized in the step of FIG.7J. As the interlayer insulation film 26 is excellently planarized, it is possible to form the insulation film 26 with an exact thickness by a CVD process or other similar deposition process.

Next, in the step of FIG.7K, a contact hole 27A is formed in the interlayer insulation film 27 so as to expose the conductor layer 25. Further, a TiN layer 28a and a W layer 28 are deposited consecutively on the interlayer insulation film 27 in the step of FIG.7L so as to fill the contact hole 27A, and the step of FIG.7M is conducted in which the W layer 28 is removed by a CMP process that uses MnO₂ abrasives in the slurry. As a result of the polishing, a conductive plug 28A is formed so as to fill the contact hole 27A. Similarly as before, the conductive plug 28A may include a seam 28b at the central part thereof, while no problem of corrosion of the seam occurs during the polishing process of FIG.7M.

Further, another interconnection pattern or an interlayer insulation film may be provided on the structure of FIG.7M.

The reason that the use of a slurry that includes Mn₂O₃ or Mn₃O₄ abrasives increases the polishing rate of an oxide film is understood as follows.

First, the manganese oxide causes a chemical reaction, when contacted with SiO₂ that forms the interlayer insulation film, to cut the chemical bond between Si and O atoms forming the film.

Further, as will be explained later, the Mn₂O₃ or Mn₃O₄ abrasives used in the present invention are formed by a thermal treatment of MnO₂. As a result of the thermal treatment, there occurs degassing of O₂ from MnO₂ and the MnO₂ is converted to Mn₂O₃ or Mn₃O₄. It should be noted that such a degassing of O₂ causes a formation of minute pores in the agglomerate of Mn₂O₃ or Mn₃O₄, and the agglomerate of Mn₂O₃ or Mn₃O₄ thus formed is easily crushed at the time of milling even when the proportion of zirconia balls is reduced in the mill. Further, the abrasives of Mn₂O₃ or Mn₃O₄ thus obtained include a large amount of pores and are easily crumbled at the time of polishing. Thereby, the area of contact between the work and the abrasives is increased during the polishing process.

### [FOURTH EMBODIMENT]

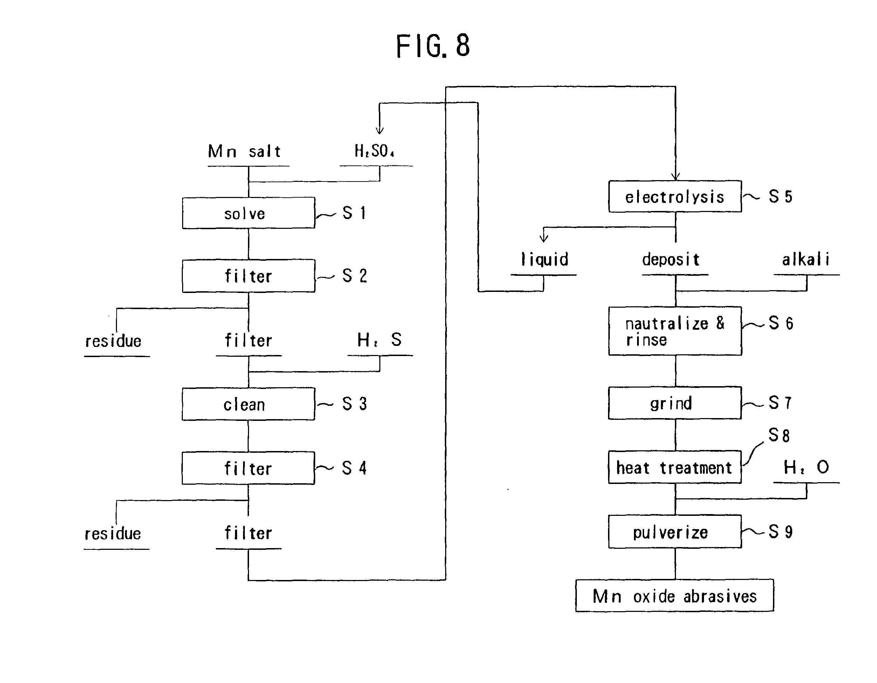

Next, the process for producing the slurry that contains Mn₂O₃ or Mn₃O₄ abrasives will be described with reference to FIG.8 showing a flowchart.

Referring to FIG.8, the process starts with a step S1 in which a manganese salt such as MnSO₄ or MnCO₃ is dissolved into a sulfuric acid (H₂SO₄), and the solution thus obtained is filtered in a step S2 for separation of any insoluble contaminants. After the step S2, the solution thus filtered is added with hydrogen sulfide (H₂S) such that metal contaminants such as Cu, W, Mo, and the like, are removed from the solution by causing a precipitation. The process of the step S3 may be omitted when a high purity source material is used in the step S1.

After the step S3, a filtering process is carried out in a step S4 for separation of any precipitates that has been formed in the step S3, and the process proceeds further to a step S5 wherein an electrolysis is applied to the solution obtained in the step S4 at a temperature of typically 90°C or more. As a result of the electrolysis process, there occurs an electro-deposition of τ-phase MnO₂ (τ-phase EMD) on an anode electrode, which may be formed of Ti, Pb or a graphite. Typically, the solution contains MnSO₄ with a concentration of 0.5 - 1.2 mol/l and H₂SO₄ with a concentration of 0.5 - 1.2 mol/l, and the electrolysis is carried out at a temperature between 90°C and 98°C while supplying a current with a current density of 50 - 120 A/m². After the electrolysis in the step S5, the solution is reused in the step S1.

The τ-phase EMD precipitates thus obtained on the anode electrode is then neutralized by NH₄OH in a subsequent step S6, and a coarse grinding process is applied thereto in a step S7 to form aggregates of the τ-phase EMD. Further, the aggregates are calcinated in a step S8 in the air for 5 - 10 minutes, typically for 7 minutes, wherein the majority of MnO₂ thus obtained is converted to Mn₂O₃ or Mn₃O₄. When forming Mn₂O₃, the calcination is conducted at a temperature of 500 - 900°C, while the temperature is set to 900 - 1200°C when obtaining Mn₃O₄.

The Mn₂O₃ or Mn₃O₄ product thus obtained is then pulverized in a subsequent step S9 by a milling process conducted in water to form abrasives having a diameter of 1 - 0.1 µm or less.

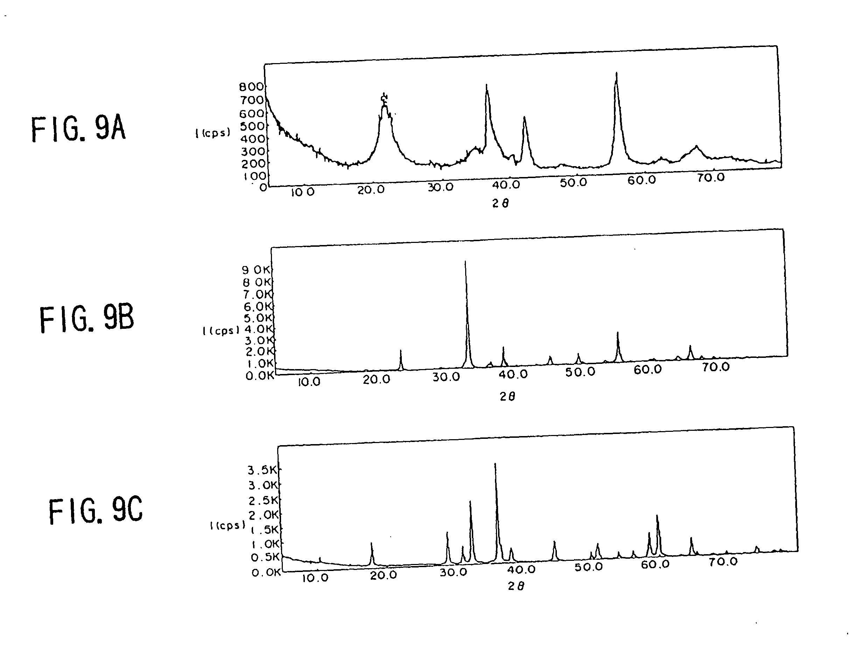

FIGS.9A - 9C show the change of the powder X-ray diffraction pattern of the manganese oxide caused as a result of the heat-treatment process.

Referring to FIGS.9A - 9C, the diffraction pattern of the τ-phase MnO₂ shown in FIG.9A changes to the diffraction pattern of Mn₂O₃ shown in FIG.9B after a calcination in the air at 500 - 900°C. Further, the diffraction pattern changes further to the pattern of Mn₃O₄ shown in FIG.9C after a calcination in the air at 900 - 1200°C.

According to the present embodiment, the polishing rate of an interlayer insulation film is increased substantially by using the abrasives of Mn₂O₃ or Mn₃O₄ as explained already. Thereby, the interlayer insulation film is not merely planarized but the thickness thereof is controlled exactly by providing a polishing stopper underneath the interlayer insulation film with a controlled thickness. Further, both of the Mn₂O₃ and Mn₃O₄ abrasives are soluble to an acid and can be removed completely by an acid bath as explained with reference to the first embodiment.

### [FIFTH EMBODIMENT]

In conventional CMP processes that uses SiO₂ or Al₂O₃ slurries, recycling or reuse of the used abrasives is not practiced commonly, due to the difficulty of recovering the used abrasives by a simple sedimentation process. It should be noted that the abrasives of a slurry are required to show an excellent dispersion in a dispersion medium and do not cause a sedimentation easily. When abrasives show a high sedimentation rate, the concentration of the abrasives in the slurry may change with time and the control of the polishing rate would become difficult. Further, even when some of the abrasives are recovered, such used abrasives are generally contaminated by various impurity elements and the reuse of the same in a CMP process is thought to be difficult.

On the other hand, the slurry described heretofore that uses a manganese oxide for the abrasives opens the possibility of recycling and reusing the abrasives.

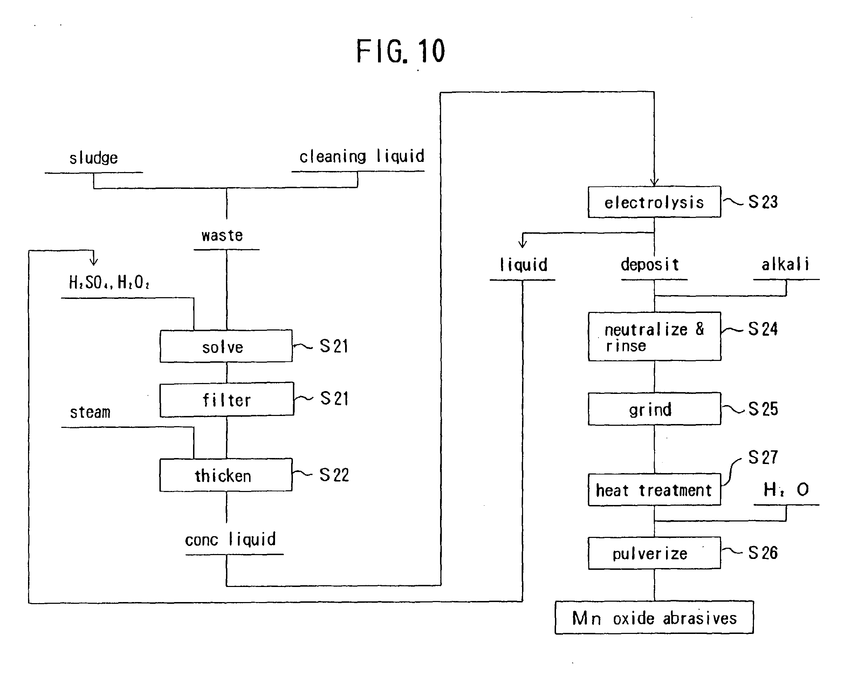

FIG.10 shows a fifth embodiment of the present invention for recycling the MnO₂ abrasives.

Referring to FIG.10, the abrasives as well as the cleaning liquid used in the CMP process are recovered as a sludge, wherein it should be noted that the sludge thus recovered contains various impurity elements constituting the conductor layer or the insulation layer to which the CMP process has been applied. Similar impurities are formed also when carrying out the CMP process by using the slurries containing the Mn₂O₃ or Mn₃O₄ abrasives.

The sludge thus recovered is then dissolved into a solution of H₂SO₄ and H₂O₂ in a step S21, and the solution thus dissolved the sludge is filtered in a step S211 for removal of any particulate impurities. The solution thus filtered is heated as necessary in a step S22 by contacting with a coiled heat exchanger through which a high temperature steam is supplied, such that the concentration of Mn²⁺ in the sludge increases to about 10%. Generally, a sludge thus recovered is diluted by a large amount of cleaning liquids and solutions as a result of various cleaning processes and contains the solid phase material by only about 1 - 2%. Thus, it is generally necessary to carry out the concentration step of S22 prior to the electrolytic process that is to be carried out in a subsequent step S23.

After the step of S22, the step S23 is conducted as noted above, in which the solution thus concentrated is subjected to an electrolytic process corresponding to the process of the step S5, and the precipitates obtained as a result of the electrolysis is then neutralized and cleaned by NH₄OH in a step S24 corresponding to the step S6 described previously. Further, a grinding process is applied in a step S25 corresponding to the step S7, and the MnO₂ aggregates thus grounded is heat-treated in the air in the a step S27 corresponding to the step S8. After the heat-treatment, the manganese oxide thus obtained is pulverized by a milling process conducted in a step S26, which corresponds to the step S9, by using water as a grinding medium. Thereby, Mn₂O₃ or Mn₃O₄ abrasives are obtained with the particle diameter of 0.1 - 1 *µ*m.

On the other hand, the liquid containing primarily H₂SO₄ formed in the step S23 is returned to the step S21 for reuse.

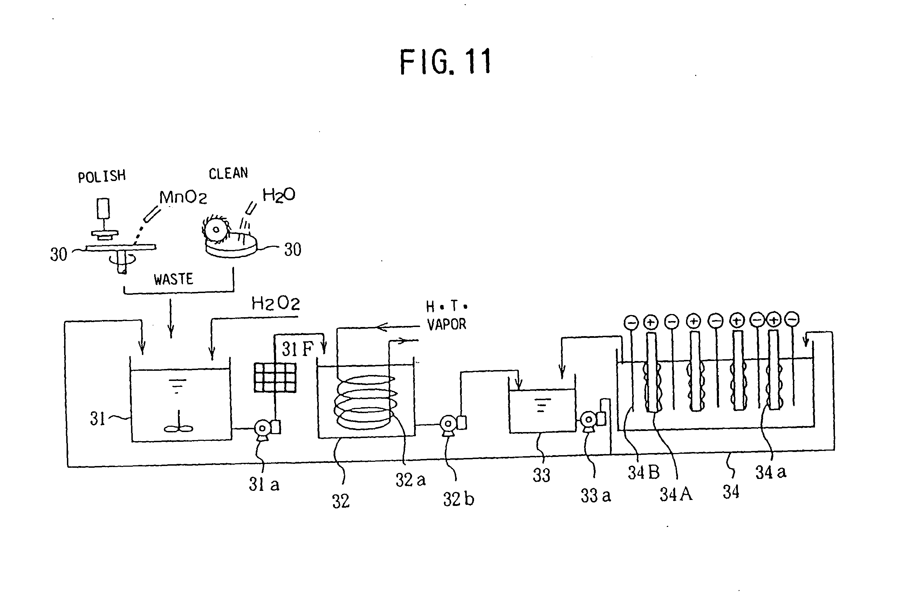

FIG.11 shows the construction for carrying out the process of FIG.10.

Referring to FIG.11, the waste slurry or sludge formed as a result of the polishing step or cleaning step of a wafer 30 is recovered in a tank 31 that contains an aqueous solution of H₂SO₄ and H₂O₂, wherein the manganese oxide abrasives in the sludge is dissolved into the foregoing aqueous solution. The aqueous solution thus dissolved the recovered abrasives is then supplied by a pump 31a to a concentration tank 32 via a filter 31F for removal of the particulate impurities, wherein the aqueous solution is concentrated in the tank 32 by an evaporation process of H₂O caused by a coiled heat exchanger 32a to which a high temperature steam is supplied. Alternatively, it is possible to use a filter such as a rotary filter press in place of the concentration tank 32.

The solution thus concentrated is then supplied to a tank 33 and further therefrom to an electrolytic bath 34 for electrolysis. As indicated in FIG.11, the electrolytic bath 34 is provided with anode electrodes 34A of Ti, Pb or a graphite and further with cathode electrodes 34B of a graphite, such that the anode electrodes 34A and the cathode electrodes 34B are arranged alternately. As a result of the electrolysis, a precipitate 34a of τ-MnO₂ is formed on the anode electrode 34A.

After the electrolysis, the electrolytic solution in the bath 34, primarily containing H₂SO₄, is returned to the tank 33 and is resupplied to the bath 34 together with a solution newly supplied to the tank 33. Further, a part of the aqueous solution in the tank 33 is returned to the tank 31 for reuse.

By carrying out the process of FIG.10 in the facility of FIG.11, it is possible to form a high purity τ-MnO₂ which is substantially free from Na and K. As the solution remaining in the electrolytic bath 34 after the electrolysis therein contains H₂SO₄ as a primary component, such a system is advantageous to construct a closed system that returns the used solution to the tank 31 as indicated by the step S21 in the process of FIG.10.

The following Table IV compares the impurity concentration in a CMD (chemically synthesized MnO₂) abrasive with the impurity concentration in an EMD (electrolytic τ-MnO₂) abrasive obtained according to the process of the present invention before and after the use.

**TABLE IV**

| | Na | K | Fe | Al | W |
|---|---|---|---|---|---|
| CMD (fresh) | 1020 | 1870 | 3200 | 3870 | 450 |
| EMD (fresh) | 80 | 77 | 67 | 12 | 438 |
| CMD (used) | 560 | 1480 | 3010 | 2430 | 100 |
| EMD (used) | 20 | 20 | 27 | 7 | 25 |

Referring to Table IV, it should be noted that the impurity concentration level is lower after the use in any of the CMD and EMD abrasives. The result of TABLE IV applies also to the Mn₂O₃ or Mn₃O₄ slurries.

In the process of FIG.11, it should be noted that the reproducing of the abrasives using the tanks 31 - 34 can be implemented in a separate plant. In such a case, however, it is necessary to transport the recovered sludge from the plant in which the production of semiconductor devices is made to the plant in which the reproducing of the abrasives is made.

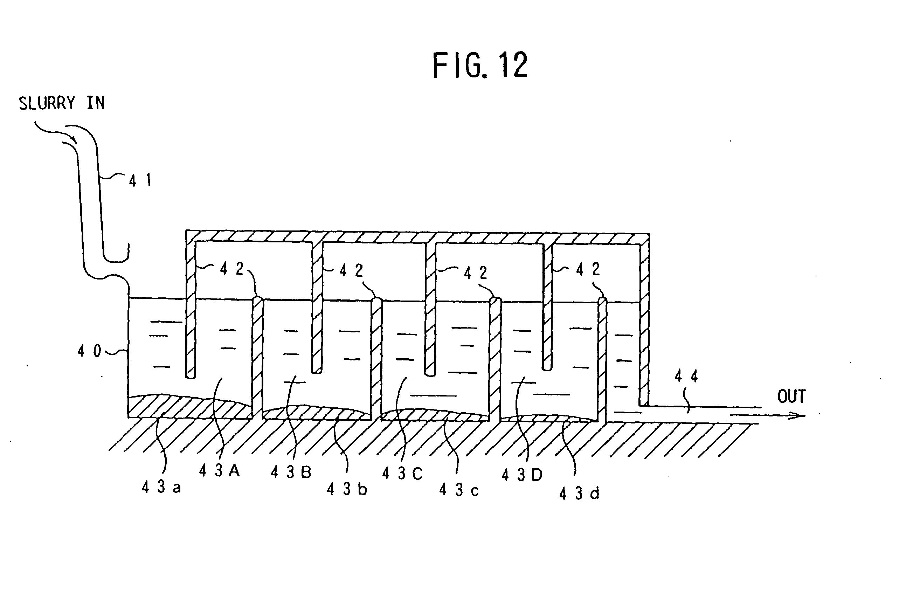

In order to reduce the cost of the transportation, it is advantageous to use a trap shown in FIG.12.

Referring to FIG.12, it should be noted that the trap is formed in a large sedimentation tank 40 divided into a plurality of sedimentation cells 43A - 43D by a plurality of compartment walls 42. Thus, the recovered sludge, which is typically diluted by a large amount of cleaning liquids as noted already, is introduced first into the sedimentation cell 43A through an inlet 41. The recovered slurry thus introduced then flows consecutively by overflowing the compartments 42 and runs out from an outlet 44. Thereby, the used abrasives are recovered in each of the cells 43A - 43D in the form of sludges 43a - 43d. By recovering the sludges, it is possible to reduce the cost of transportation substantially.

The slurry of the present invention is not only useful for the fabrication of semiconductor devices but also for the polishing of a lens or the fabrication of liquid crystal panels, plasma display panels or a reticle.

Further, the present invention is not limited to the embodiments described heretofore, but various variations and modifications may be made without departing from the scope of the invention.

## Claims

1. Use of a slurry for polishing an insulation film (9, 13, 16), the said slurry comprising: abrasive particles causing polishing of said insulation film (9, 13, 16); and a solvent in which said abrasive particles are dispersed, said abrasive particles being selected from a group consisting of Mn₂O₃, Mn₃O₄ and a mixture thereof.

2. Use of a slurry as claimed in claim 1, wherein said abrasive particles have an average grain size of 1 µm or less.

3. Use of a slurry as claimed in claim 1 or 2, wherein said abrasive particles have an average grain size of about 0.2 µm.

4. Use of a slurry as claimed in any one of claims 1 to 3, wherein said solvent includes H₂O.

5. A method of polishing an insulation film (9, 13, 16), comprising the step of: polishing said insulation film (9, 13, 16) by a slurry comprising abrasive particles and a solvent, said abrasive particles being selected from a group consisting of Mn₂O₃, Mn₃O₄ and a mixture thereof.

6. A method as claimed in claim 5, wherein said insulation film (9, 13, 16) is an SiO₂ film.

7. A method as claimed in claim 5, wherein said insulation film (13, 16) is a silicate glass.

8. A method as claimed in any one of claims 5 to 7, wherein said step of polishing is conducted selectively with respect to a conductor layer (13, 14c, 17, 17a, 24c, 25, 25b, 28a) or a semiconductor layer (8) provided underneath said insulation film (9, 13, 16).

9. A method as claimed in claim 8, wherein said conductor layer is a W layer (13, 17, 25) or a TiN layer (14c, 17a, 24c, 25b, 28a).

10. A method as claimed in claim 8, wherein said semiconductor layer (8) is a Si layer or a Si substrate.

11. A method as claimed in any one of claims 8 to 10, for use in fabricating a semiconductor device.

12. A method as claimed in claim 11, wherein said method further comprises the steps of: forming a groove (8A) on a semiconductor substrate (8); and providing said insulation film (9) on said semiconductor substrate (8) so as to fill said groove; wherein said polishing step is conducted such that said insulation film is removed from a surface of said semiconductor substrate.

13. A method as claimed in claim 12, wherein said polishing step is conducted such that said surface of said substrate (8) is exposed as a result of said polishing step.

14. A method as claimed in claim 12 or 13, wherein said polishing step is conducted such that said surface of said substrate (8) forms a flush, planarized surface with a surface of said insulation layer (9).

15. A method as claimed in claim 11, wherein said method further comprises the steps of: forming an interconnection pattern (15, 15b) on a substrate (11, 21); and providing said insulation film (16) on said substrate so as to cover said interconnection pattern; wherein said polishing step is conducted so as to planarize said insulation film.

16. A method as claimed in claim 15, wherein said polishing step is conducted until said interconnection pattern (25, 25b) is exposed.

17. A method as claimed in claim 15, wherein said step of forming said interconnection pattern is conducted such that said interconnection pattern is covered by a TiN layer (15b, 25b).

18. A method as claimed in claim 11, wherein the method further comprises the steps of; providing a first insulation layer (13, 23) on said substrate (11, 21); forming a groove (13a, 23a) in said first insulation layer; providing a conductor layer (15, 25) on said first insulation layer so as to fill said groove; polishing said conductor layer by a slurry that contains MnO₂ abrasives, until said first insulation layer is exposed, said conductor layer filling said groove thereby forming a conductive pattern embedded in said groove; providing a second insulation layer (16, 26) on said first insulation layer including said conductive pattern, as said insulation film; wherein said polishing step, conducted on said insulation film (16, 26) by said slurry that contains manganese oxide abrasives selected from a group consisting of Mn₂O₃, Mn₃O₄ and a mixture thereof, is conducted on said second insulation layer.

19. A method as claimed in any one of claims 15 to 18, wherein said insulation film (16) is an SiO₂ film.

20. A method as claimed in any one of claims 15 to 18, wherein said insulation film (16) is a silicate glass film.

21. A method as claimed in any one of claims 11 to 20, further comprising the step, after said polishing step of said insulation film by said slurry that contains manganese oxide abrasives selected from a group consisting of Mn₂O₃, Mn₃O₄ and a mixture thereof, of dissolving said manganese abrasives by an acid bath.

22. A method as claimed in claim 21, wherein said acid bath contains HCl.

23. A method as claimed in claim 21 or 22, further comprising the step of dissolving said MnO₂ abrasives by said acid bath.

## Patentansprüche

1. Verwendung eines Nassschlamms zum Polieren eines Isolierfilms (9, 13, 16), wobei der Nassschlamm umfasst: Schleifpartikel, die das Polieren des Isolierfilms (9, 13, 16) verursachen; und ein Lösungsmittel, in dem die Schleifpartikel dispergiert sind, wobei die Schleifpartikel aus einer Gruppe, bestehend aus Mn₂O₃, Mn₃O₄ und einer Mischung daraus, ausgewählt sind.

2. Verwendung eines Nassschlamms gemäß Anspruch 1, worin die Schleifpartikel eine mittlere Korngröße von 1 µm oder weniger aufweisen.

3. Verwendung eines Nassschlamms gemäß Anspruch 1 oder 2, worin die Schleifpartikel eine mittlere Korngröße von etwa 0,2 µm aufweisen.

4. Verwendung eines Nassschlamms gemäß einem der Ansprüche 1 bis 3, worin das Lösungsmittel H₂O enthält.

5. Verfahren zum Polieren eines Isolierfilms (9, 13, 16), umfassend die Schritte: Polieren des Isollerfilms (9, 13, 16) durch einen Nassschlamm, der Schleifpartikel und ein Lösungsmittel enthält, wobei die Schleifpartikel aus einer Gruppe, bestehend aus Mn₂O₃, Mn₃O₄ und einer Mischung daraus, ausgewählt sind.

6. Verfahren gemäß Anspruch 5, worin der Isolierfilm (9, 13, 16) ein SiO₂-Film ist.

7. Verfahren gemäß Anspruch 5, worin der Isolierfilm (13, 16) ein Silikatglas ist

8. Verfahren gemäß einem der Ansprüche 5 bis 7, worin der Polierschritt bezüglich einer Leiterschicht (13, 14c, 17, 17a, 24c, 25, 25b, 28a) oder einer Halbleiterschicht (8), die unterhalb des Isolierfilms (9, 13, 16) vorgesehen sind, selektiv durchgeführt wird.

9. Verfahren gemäß Anspruch 8, worin die Leiterschicht eine W-Schicht (13, 17, 25) oder eine TiN-Schicht (14c, 17a, 24c, 25b, 28a) ist.

10. Verfahren gemäß Anspruch 8, worin die Halbleiterschicht (8) eine Si-Schicht oder ein Si-Substrat ist.

11. Verfahren gemäß einem der Ansprüche 8 bis 10 zu Verwendung bei der Herstellung eines Halbleiterbauelements.

12. Verfahren gemäß Anspruch 11, worin das Verfahren ferner die Schritte umfasst: Ausbilden einer Nut (8A) auf einem Halbleitersubstrat (8); und Aufbringen des Isolierfilms (9) auf das Halbleitersubstrat (8), um die Nut zu füllen; worin der Pollerschritt so durchgeführt wird, dass der Isolierfilm von einer Oberfläche des Halbleitersubstrats entfemt wird.

13. Verfahren gemäß Anspruch 12, worin der Pollerschritt so durchgeführt wird, dass die Oberfläche des Substrats (8) als Resultat des Polierschrittes freiliegt.

14. Verfahren gemäß Anspruch 12 oder 13, worin der Poilerschritt so durchgeführt wird, dass die Oberfläche des Substrats (8) eine bündige, eingeebnete Oberfläche mit einer Oberfläche der Isolierschicht (9) bildet.

15. Verfahren gemäß Anspruch 11, worin das Verfahren ferner die Schritte umfasst: Ausbilden eines Zwischenverbindungsmuster (15, 15b) auf einem Substrat (11, 21); und Aufbringen des Isolierfilms (16) auf das Substrat, um das Zwischenverbindungsmuster zu bedecken; worin der Polierschritt so durchgeführt wird, dass der Isolierfilm eingeebnet wird.

16. Verfahren gemäß Anspruch 15, worin der Polierschritt durchgeführt wird, bis das Zwischenverbindungsmuster (25, 25b) freiliegt.

17. Verfahren gemäß Anspruch 15, worin der Schritt des Ausbildens des Zwischenverbindungsmusters so durchgeführt wird, dass das Zwischenverbindungsmuster durch eine TiN-Schicht (15b, 25b) bedeckt ist.

18. Verfahren gemäß Anspruch 11, worin das Verfahren ferner die Schritte umfasst: Aufbringen einer ersten Isolierschicht (13, 23) auf das Substrat (11, 21); Ausbilden einer Nut (13a, 23a) in der ersten Isolierschicht; Aufbringen einer Leiterschicht (15, 25) auf der ersten Isolierschicht, um die Nut zu füllen; Polieren der Leiterschicht mit einem Nassschlamm, der MnO₂-Schleifmittel enthält, bis die erste Isolierschicht freiliegt; wobei die Leiterschicht, die die Nut füllt, **dadurch** ein in die Nut eingebettetes, leitendes Muster bildet; Aufbringen einer zweiten Isolierschicht (16, 26) auf die erste Isolierschicht, die das leitende Muster beinhaltet, als Isolierfilm; worin der Polierschritt, der auf dem Isolierfilm (16, 26) mittels des Nassschlamms durchgeführt wird, der Manganoxid-Schleifmittel enthält, die aus einer Gruppe, bestehend aus Mn₂O₃, Mn₃O₄ und Mischungen daraus, ausgewählt sind, auf der zweiten Isolierschicht durchgeführt wird.

19. Verfahren gemäß einem der Ansprüche 15 bis 18, worin der Isolierfilm (16) ein SiO₂-Film ist.

20. Verfahren gemäß einem der Ansprüche 15 bis 18, worin der Isolierfilm (16) ein Silikatglas-Film ist.

21. Verfahren gemäß einem der Ansprüche 11 bis 20, ferner umfassend nach dem Polierschritt des Isolierfilms mittels des Nassschlamms, der Manganoxid-Schleifmittel enthält, die aus einer Gruppe, bestehend aus Mn₂O₃, Mn₃O₄ und Mischungen daraus, ausgewählt sind, einen Schritt des Lösens der Mangan-Schleifmittel durch ein Säurebad.

22. Verfahren gemäß Anspruch 21, worin das Säurebad HCl enthält.

23. Verfahren gemäß Anspruch 21 oder 22, welches ferner den Schritt des Lösens des MnO₂-Schleifmittels durch das Säurebad beinhaltet.

## Revendications

1. Utilisation d'une suspension de polissage d'un film isolant (9, 13, 16), ladite suspension comprenant : des particules abrasives entraînant le polissage dudit film isolant (9, 13, 16) ; et un solvant dans lequel lesdites particules abrasives sont dispersées, lesdites particules abrasives étant choisies dans le groupe constitué de Mn₂O₃, Mn₃O₄ et d'un mélange de ceux-ci.

2. Utilisation d'une suspension selon la revendication 1, dans laquelle lesdites particules abrasives présentent une taille moyenne de particule de 1 µm ou inférieure.

3. Utilisation d'une suspension selon la revendication 1 ou 2, dans laquelle lesdites particules abrasives présentent une taille moyenne de particule d'environ 0,2 µm.

4. Utilisation d'une suspension selon l'une quelconque des revendications 1 à 3, dans laquelle ledit solvant comprend H₂O.

5. Procédé de polissage d'un film isolant (9, 13, 16), comprenant l'étape consistant à polir ledit film isolant (9, 13, 16) avec une suspension comprenant des particules abrasives et un solvant, lesdites particules abrasives étant choisies dans un groupe comprenant Mn₂O₃, Mn₃O₄ et un mélange de ceux-ci.

6. Procédé selon la revendication 5, dans lequel ledit film isolant (9, 13, 16) est un film de SiO₂.

7. Procédé selon la revendication 5, dans lequel ledit film isolant (13, 16) est un verre de silicate.

8. Procédé selon l'une quelconque des revendications 5 à 7, dans lequel l'étape de polissage est réalisée sélectivement par rapport à une couche conductrice (13, 14c, 17, 17a, 24c, 25, 25b, 28a) ou une couche semi-conductrice (8) placée sous ledit film isolant (9, 13, 16).

9. Procédé selon la revendication 8, dans lequel ladite couche conductrice est une couche de W (13, 17, 25) ou une couche de TiN (14c, 17a, 24c, 25b, 28a).

10. Procédé selon la revendication 8, dans lequel ladite couche semi-conductrice (8) est une couche de Si ou un substrat de Si.

11. Procédé selon l'une quelconque des revendications 8 à 10, utilisé dans la fabrication d'un dispositif semi-conducteur.

12. Procédé selon la revendication 11, dans lequel ledit procédé comprend en outre les étapes consistant à former un sillon (8A) sur un substrat semi-conducteur (8) ; et à placer ledit film isolant (9) sur ledit substrat semi-conducteur (8) de façon à remplir ledit sillon ; dans lequel ladite étape de polissage est réalisée de telle sorte que ledit film isolant soit retiré d'une surface dudit substrat semi-conducteur.

13. Procédé selon la revendication 12, dans lequel ladite étape de polissage est réalisée de telle sorte que ladite surface dudit substrat (8) soit exposée en conséquence de ladite étape de polissage.

14. Procédé selon la revendication 12 ou 13, dans lequel ladite étape de polissage est réalisée de telle sorte que ladite surface dudit substrat (8) forme une surface aplanie, de niveau avec une surface de ladite couche isolante (9).

15. Procédé selon la revendication 11, dans lequel ledit procédé comprend en outre les étapes consistant à former un schéma d'interconnexion (15, 15b) sur un substrat (11, 21) ; et à placer ledit film isolant (16) sur ledit substrat de façon à couvrir ledit schéma d'interconnexion ; dans lequel ladite étape de polissage est réalisée de façon à aplanir ledit film isolant.

16. Procédé selon la revendication 15, dans lequel ladite étape de polissage est réalisée jusqu'à ce que ledit schéma d'interconnexion (25, 25b) soit exposé.

17. Procédé selon la revendication 15, dans lequel ladite étape de formation dudit schéma d'interconnexion est réalisée de telle sorte que ledit schéma d'interconnexion soit recouvert par une couche de TiN (15b, 25b).

18. Procédé selon la revendication 11, dans lequel le procédé comprend en outre les étapes consistant à placer une première couche isolante (13, 23) sur ledit substrat (11, 21) ; à former un sillon (13a, 23a) dans ladite première couche isolante ; à placer une couche conductrice (15, 25) sur ladite première couche isolante de façon à combler ledit sillon ; à polir ladite couche conductrice avec une suspension qui contient des abrasifs à base de MnO₂ jusqu'à ce que ladite première couche isolante soit exposée, ladite couche conductrice comblant ledit sillon, formant ainsi un schéma conducteur intégré dans ledit sillon ; à placer une deuxième couche isolante (16, 26) sur ladite première couche isolante comprenant ledit schéma conducteur, en tant que ledit film isolant ; dans lequel ladite étape de polissage réalisée sur ledit film isolant (16, 26) par ladite suspension qui contient des abrasifs à base d'oxyde de manganèse choisis dans un groupe comprenant Mn₂O₃, Mn₃O₄ et un mélange de ceux-ci, est réalisée sur ladite deuxième couche isolante.

19. Procédé selon l'une quelconque des revendications 15 à 18, dans lequel ledit film isolant (16) est un film de SiO₂.

20. Procédé selon l'une quelconque des revendications 15 à 18, dans lequel ledit film isolant (16) est un film en verre de silicate.

21. Procédé selon l'une quelconque des revendications 11 à 20, comprenant en outre l'étape consistant à dissoudre, après ladite étape de polissage dudit film isolant par ladite suspension qui contient des abrasifs à base d'oxyde de manganèse choisi dans un groupe comprenant Mn₂O₃, Mn₃O₄ et un mélange de ceux-ci, lesdits abrasifs à base de manganèse par un bain acide.

22. Procédé selon la revendication 21, dans laquelle le bain acide contient du HCl.

23. Procédé selon la revendication 21 ou 22, comprenant en outre l'étape consistant à dissoudre lesdits abrasifs à base de MnO₂ par ledit bain acide.
